# FASCICULE DE BREVET EUROPEEN

(11) **EP 2 774 211 B1**
(45) Date de publication et mention de la délivrance du brevet: **04.12.2019**
(21) Numéro de dépôt: 12780491.2
(22) Date de dépôt: 30.10.2012
(51) Int. Cl.: H01P 1/23, H01P 1/203, H01F 17/00, H01F 17/04, H01F 19/04, H01F 27/28, H01F 41/04, H05K 1/02, H05K 1/03, H05K 1/16, H05K 3/14

(54) **DISPOSITIF DE FILTRAGE CEM SUR CIRCUIT IMPRIME**
VORRICHTUNG ZUR EMV-FILTERUNG AUF EINER LEITERPLATTE
DEVICE FOR EMC FILTERING ON A PRINTED CIRCUIT

(30) Priorité: 04.11.2011 FR 1160030
(43) Date de publication de la demande: 10.09.2014
(73) Titulaire: AIRBUS (SAS), 31700 Blagnac (FR)
(72) Inventeur: MEYER, Marc, F-31330 Launac (FR)
(74) Mandataire: Gicquel, Olivier Yves Gérard
(86) Numéro de dépôt international: PCT/EP2012/071518
(87) Numéro de publication internationale: WO 2013/064516

(56) Documents cités:
- WO-A1-2008/048040
- JP-A- 2001 267 129
- US-A1- 2003 137 384
- US-A1- 2007 158 105
- US-A1- 2008 238 601
- US-A1- 2010 003 479

## Description

### DOMAINE TECHNIQUE DE L'INVENTION

L'invention se rapporte au domaine de l'Electronique.

L'invention concerne plus particulièrement un dispositif de filtrage CEM *(« Compatibilité Electromagnétique* ») sur circuit imprimé.

Les applications de l'invention sont notamment celles de l'électronique de puissance, c'est-à-dire en particulier les convertisseurs de puissance, et celles de l'électronique analogique et numérique.

### ETAT DE LA TECHNIQUE

L'arrivée de nouvelles technologies de semi-conducteurs ont permis de travailler à haute température, de réduire la taille des éléments de dissipation thermique et d'élever les fréquences de découpage.

L'augmentation des fréquences de découpage a entraîné un déploiement du spectre des émissions conduites et rayonnées à des fréquences plus élevées.

Des normes, comme par exemple la norme D0160 dans l'aéronautique, la norme CISPR25 dans l'automobile et la norme MILSTD dans le domaine militaire, exigent que les émissions conduites soient inférieures à un seuil compris entre 10 kiloHertz et 100 MégaHertz voire 150 MégaHertz.

Il est donc nécessaire de produire des dispositifs de filtrage réduisant au dessous de 100 MégaHertz le spectre des émissions conduites et rayonnées. En outre, il est nécessaire de réduire le volume occupé par les dispositifs de filtrage, ainsi que de réduire des éléments parasites de ces dispositifs de filtrage, comme l'inductance créée en série avec les condensateurs et la capacité créée en parallèle aux bobines.

On connait des dispositifs de filtrage, de volume réduit, permettant de réduire le spectre des émissions conduites à des fréquences comprises entre 10 MégaHertz et 100 MégaHertz, où les éléments de filtrage discrets ont des performances souvent insuffisantes à cause des éléments parasites précédemment explicités, tout en limitant les éléments parasites des éléments de filtrage.

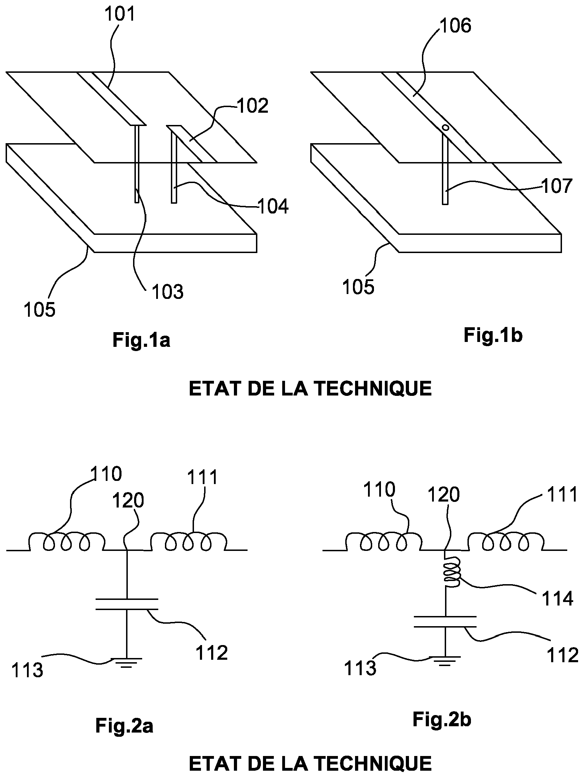

Les Figures 1a, 2a montrent un tel dispositif de filtrage permettant de limiter la création de l'inductance en série avec les condensateurs alors que les Figures 1b, 2b montrent un dispositif de filtrage ne permettant pas de limiter la création de l'inductance en série avec les condensateurs.

Le dispositif de filtrage montré en Figure 1a comporte des pistes 101, 102 conductrices comportant chacune une via 103, 104 et un film 105 diélectrique d'épaisseur comprise entre 8 micromètres et 32 micromètres intercalé entre deux électrodes métalliques en cuivre d'épaisseur comprise entre 15 micromètres et 35 micromètres. Le positionnement de ces éléments 101-105 permet d'avoir un schéma équivalent présenté en Figure 2a. Ce schéma équivalent présente deux bobines 110, 111 et un condensateur 112 relié à la masse 113 ayant un nœud 120 commun avec les deux bobines 110, 111.

Le dispositif de filtrage montré en Figure 1b comporte une piste 106 conductrice comportant une via 107 et un un film 105 diélectrique d'épaisseur comprise entre 8 micromètres et 32 micromètres intercalé entre deux électrodes métalliques en cuivre d'épaisseur comprise entre 15 micromètres et 35 micromètres. Le positionnement de ces éléments 105-107 permet d'avoir un schéma équivalent présenté en Figure 2a. Ce schéma équivalent présente deux bobines 110, 111 et un condensateur 112, relié à la masse 113 et en série avec une bobine 114 ayant un nœud 120 commun avec les deux bobines 110, 111.

En comportant deux pistes 101, 102 conductrices et deux vias 103, 104 au lieu d'une piste 106 conductrice et d'une via 107, comme le dispositif de filtrage montré en Figure 2a, le dispositif de filtrage montré en Figure 1a permet ainsi d'obtenir un condensateur 112 sans créer d'inductance 114 parasite en série avec ce condensateur 112. La capacité du condensateur 112 dépend de la permittivité et de l'épaisseur du film 105 diélectrique. Plus l'épaisseur du film 105 diélectrique est petite, plus la capacité du condensateur 112 est forte et plus la permittivité du film 105 diélectrique est élevée, plus la capacité du condensateur 112 est forte.

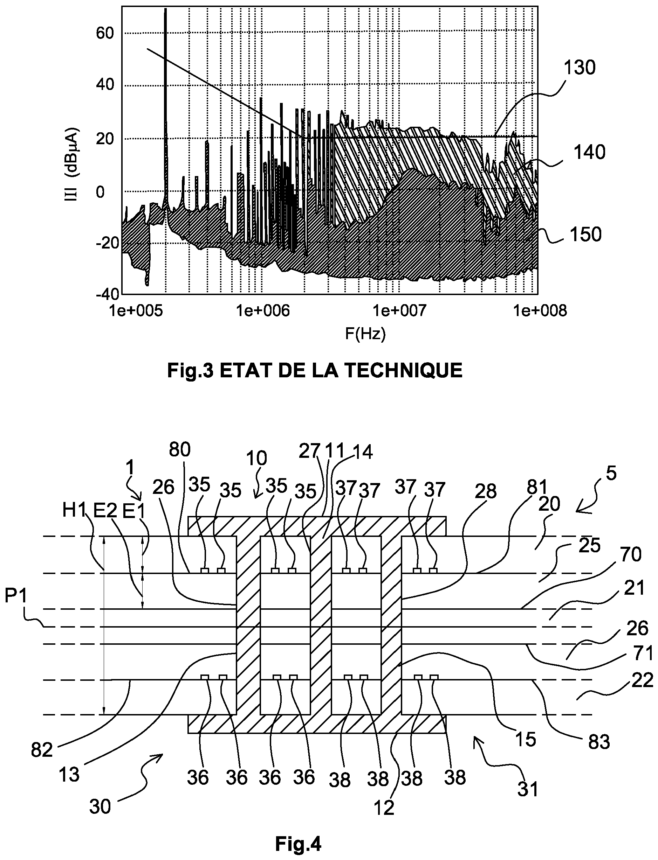

La Figure 3 est un graphique montrant le niveau de courant |I| en décibel microAmpère en fonction de la fréquence en Hertz. Le niveau de courant |I| est mesuré avec un analyseur de spectre et en conditions d'essai normatif. La courbe 130 indique la limitation en niveau |I| de courant en fonction de la fréquence imposée par la norme DO160, la courbe 140 montre le niveau |I| de courant d'un condensateur pour alimentation à découpage sans dispositif de filtrage de la Figure 1a en fonction de la fréquence et la courbe 150 montre le niveau |I| de courant d'un condensateur pour alimentation à découpage avec dispositif de filtrage de la Figure 1a en fonction de la fréquence. La courbe 150 reste globalement pour toute la gamme de fréquence montrée en dessous de la courbe 130, alors que la courbe 140 dépasse la courbe 130 à partir d'une fréquence de 1 MégaHertz. Le dispositif de filtrage de la Figure 1a permet ainsi de rester en dessous de la limitation en niveau |I| de courant imposée par la norme DO160 sur une gamme de fréquences, alors qu'un filtre passif simple permet de réduire le premier harmonique à 200 kiloHertz.

Cependant, l'intégration de ce dispositif de filtrage au circuit intégré ne permet pas d'obtenir des bobines 110, 111 d'inductance élevée.

On connait du document US2008/238601 un transformateur comportant un circuit imprimé comportant au moins deux couches parallèles, un noyau comportant trois bras cylindriques traversant perpendiculairement les couches, plusieurs couches de matériau isolant, une bobine s'enroulant autour d'un premier bras du noyau en matériau magnétique et une bobine s'enroulant autour du deuxième bras du noyau en matériau magnétique. Ce dispositif ne permet pas d'obtenir des bobines d'inductance élevée.

Afin de résoudre ce problème, on connaît des dispositifs de filtrages intégrés à des circuits imprimés comportant des couches composées de matériaux magnétiques, mais ces dispositifs sont coûteux, difficiles à fabriquer et non fiables.

On connaît en outre, par exemple par la publication scientifique « Estimation des pertes cuivre dans des composants magnétiques planar - Application au LCT - LAI DAC Kien - JCGE'08 Lyon - 16 et 17 décembre 2008 *»,* des composants magnétiques de type « planar » comportant un transformateur, des bobines et des condensateurs, intégrés à un circuit imprimé comportant des éléments de ferrite, pour lesquels la fabrication du circuit imprimé est dissociée de la fabrication des éléments de ferrite. Cependant, l'application de ces composants magnétiques n'est pas le filtrage mais un transformateur.

On connait, de même, le document US2003/137384 qui décrit un dispositif de filtrage comportant un noyau en matériau magnétique, plusieurs couches de matériau isolant, deux bobinages s'enroulant autour d'un premier bras du noyau en matériau magnétique et au moins deux bobinages s'enroulant autour du deuxième bras du noyau en matériau magnétique. Ce dispositif ne permet pas la réduction des couplages capacitifs des bobines et est moins performant sur la gamme des fréquences la plus élevée du spectre des émissions conduites et rayonnées.

Le document US2007/158105 décrit un tableau de connexions multicouche ayant une fonction capacitive entre une couche d'alimentation électrique et une couche de masse permettant de supprimer le bruit dudit tableau.

Enfin, le document WO2008/048040 décrit un transformateur comportant un noyau en matériau magnétique comportant un entrefer.

### OBJET DE L'INVENTION

L'invention a notamment pour but de proposer un dispositif de filtrage CEM fiable, facile à fabriquer, de volume réduit permettant de réduire en dessous de 100 mégahertz le spectre des émissions conduites et rayonnées grâce à la réduction des éléments parasites des éléments de filtrage.

A cette fin, l'invention concerne un dispositif de filtrage CEM, selon la revendication 1.

Selon une réalisation,
- le premier bobinage de chaque bobine est positionné sur la face supérieure de la première couche de matériau à forte permittivité étant en contact avec la première couche de matériau isolant,
- le deuxième bobinage de chaque bobine est positionné sur la face inférieure de la deuxième couche de matériau à forte permittivité étant en contact avec la deuxième couche de matériau isolant.

Selon une réalisation, les bobinages des deux bobines sont plans.

Selon une réalisation, les bobinages des deux bobines sont enroulés dans le même sens, permettant de créer des bobines couplées de mode commun.

Selon une réalisation, les bobinages de la première bobine sont enroulés dans le sens contraire de l'enroulement des bobinages de la deuxième bobine, permettant de créer des bobines couplées de mode différentiel.

Selon une réalisation, les couches de matériau à forte permittivité sont en matériau de type C-ply.

Selon une réalisation, le noyau en matériau magnétique est en ferrite.

Selon une réalisation, les couches de matériau diélectrique sont en matériau de type FR4.

Selon une réalisation, le circuit imprimé et les bras du noyau sont de hauteur comprise entre un millimètre et trois millimètres.

### BREVE DESCRIPTION DES FIGURES

L'invention sera mieux comprise à la lecture de la description qui suit et à l'examen des figures qui l'accompagnent. Ces figures ne sont données qu'à titre illustratif mais nullement limitatif de l'invention. Elles montrent :
Figures 1a-1b (déjà décrite) : des représentations schématiques de dispositifs de filtrage selon l'état de la technique ;
Figures 2a-2b (déjà décrites) : des représentations schématiques de dispositifs de filtrage selon l'état de la technique ;
Figure 3 (déjà décrite) : une représentation graphique du niveau de courant |I| en fonction de la fréquence d'un condensateur pour alimentation à découpage avec dispositif de filtrage selon l'état de la technique ;
Figure 4: une vue en coupe du dispositif de filtrage selon l'invention ;
Figure 5 : une vue en coupe d'une variante du dispositif de filtrage selon l'invention ;
Figure 6a-6b : des représentations schématiques du dispositif de filtrage selon l'invention et d'une variante du dispositif de filtrage selon l'invention ;
Figure 7 : une vue de dessus du dispositif de filtrage selon l'invention.

Les éléments identiques, similaires ou analogues conservent la même référence d'une figure à l'autre.

### DESCRIPTION D'EXEMPLES DE REALISATION DE L'INVENTION

La Figure 4 montre un dispositif 1 de filtrage CEM comportant un circuit 5 imprimé et un noyau 10 en matériau magnétique.

Le circuit 5 imprimé comporte trois couches 20, 21, 22 parallèles de matériau isolant et deux couches 25, 26 de matériau à forte permittivité, parallèles entre elles et aux couches 20, 21, 22.

Plus précisément, la couche 25 de matériau à forte permittivité est positionnée entre les couches 20 et 21 de matériau isolant et la couche 26 de matériau à forte permittivité est positionnée entre les couches 21 et 22 de matériau isolant.

Plus précisément, la couche 25 de matériau à forte permittivité comporte sur sa face supérieure, c'est-à-dire la face étant en contact avec la couche 20, un plan 80 négatif et un plan 81 positif et comporte sur sa face inférieure, c'est-à-dire la face étant en contact avec la couche 21 un plan 70 de masse. De même, la couche 26 de matériau à forte permittivité comporte sur sa face inférieure, c'est-à-dire la face étant en contact avec la couche 22 un plan 82 positif et un plan 83 négatif et comporte sur sa face supérieure, c'est-à-dire la face étant en contact avec la couche 21 un plan 71 de masse.

Selon un mode de réalisation, le circuit imprimé est de hauteur H1 comprise entre un millimètre et trois millimètres. Dans un mode de réalisation, les couches 20-22 sont d'épaisseur E1 comprise entre quatre-vingt micromètres et deux cent micromètres. et les couches 25, 26 sont d'épaisseur E2 comprise entre huit micromètres et trente deux micromètres.

La structure du circuit 5 imprimé est symétrique par rapport à un plan P1 parallèle aux couches 20, 21, 22, 25, 26 et passant par le milieu de la hauteur H1 du circuit 5 imprimé pour être compatible aux exigences de fabrication des circuits 5 imprimés, notamment au niveau de la tenue mécanique.

Dans un mode de réalisation, les couches 20, 21, 22, 25, 26 comportent chacun trois ouvertures circulaires, d'un diamètre D1 compris entre deux millimètres et quelques centimètres selon la puissance de l'équipement à filtrer, de sorte que lorsque toutes les couches 20, 21, 22, 25, 26 sont empilés, les ouvertures circulaires forment trois ouvertures 26, 27, 28 cylindriques de diamètre D1 et de hauteur H1.

Le noyau 10 en matériau magnétique comporte deux plaques 11, 12 parallélépipédiques parallèles aux couches 20, 21, 22, 25, 26 et trois bras 13, 14, 15 de forme cylindrique de diamètre D2 légèrement inférieur à D1 et de hauteur H1, de sorte que les trois bras 13, 14, 15 soient positionnés à l'intérieur des trois ouvertures 26, 27, 28 cylindriques. La plaque 11 est en contact avec la face supérieure de la couche 20 n'étant pas en contact avec la couche 25 et est reliée solidairement à une première extrémité de chaque bras 13-15. La plaque 12 est en contact avec la face de la couche 22 n'étant pas en contact avec la couche 26 et est reliée solidairement à une deuxième extrémité de chaque bras 13-15.

Le dispositif 1 de filtrage comporte en outre deux bobines couplées 30, 31 comportant chacune deux bobinages 35, 36, 37 ,38 plans et ayant les trois bras 13, 14, 15 en matériau magnétique en commun.

Plus précisément, le premier bobinage 35 de la première bobine 30 est positionné sur la face supérieure de la couche 25, c'est-à-dire la face de la couche 25 étant en contact avec la couche 20 et le deuxième bobinage 36 de la première bobine 30 est positionné sur la face inférieure de la couche 26, c'est-à-dire la face de la couche 26 étant en contact avec la couche 22. De même, le premier bobinage 37 de la deuxième bobine 31 est positionné sur la face supérieure de la couche 25, c'est-à-dire la face de la couche 25 étant en contact avec la couche 20 et le deuxième bobinage 38 de la deuxième bobine 31 est positionné sur la face inférieure de la couche 26, c'est-à-dire la face de la couche 26 étant en contact avec la couche 22.

Les bobinages 35, 36 s'enroulent autour du bras 13 tandis que les bobinages 37, 38 s'enroulent autour du bras 15.

Les bobinages 35, 36, 37, 38 comportent une largeur comprise entre un millimètre et un centimètre. Le nombre d'enroulements des bobinages 35, 36, 37, 38 varie entre un enroulement et dix enroulements.

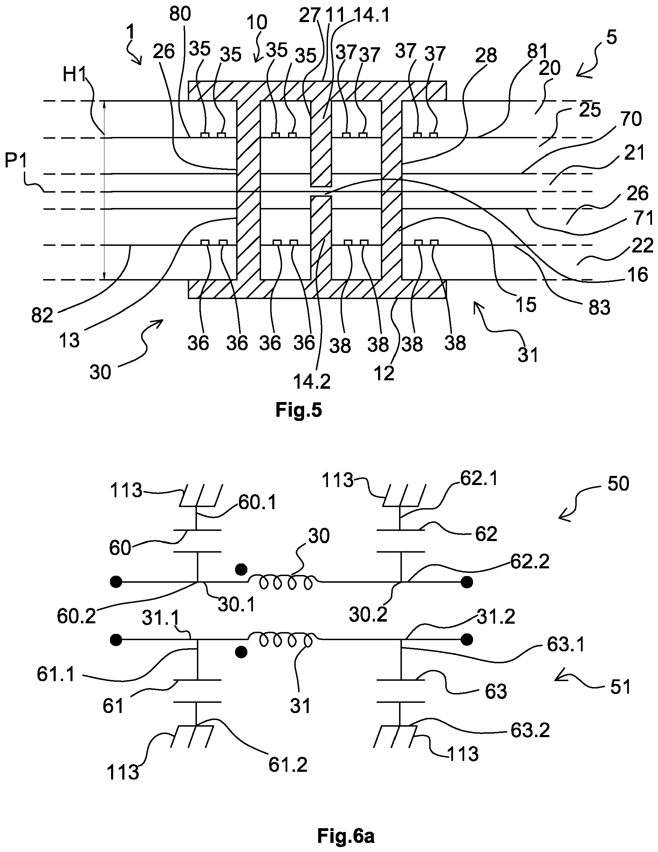

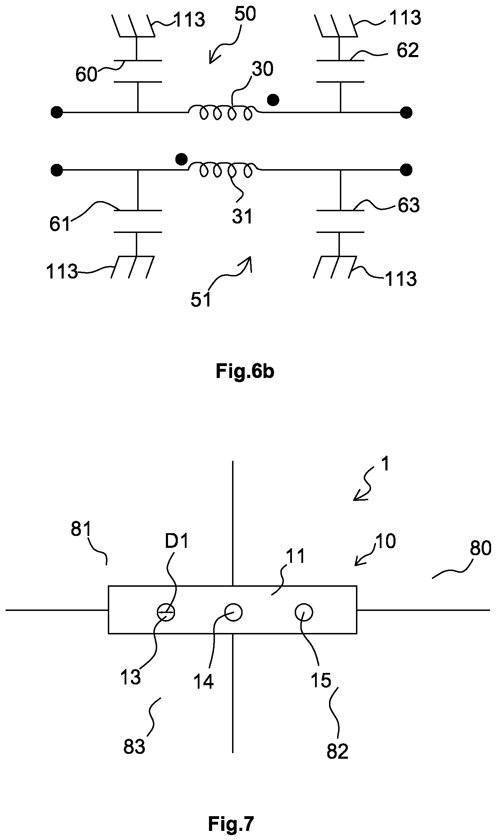

Le positionnement des bobinages 35, 36, 37, 38, des plans 70, 71, 80-83 et des couches 20-22, 25, 26 permet d'obtenir deux cellules 50, 51 de « filtrage en pi », comportant chacune deux condensateurs 60-63 et une bobine 30, 31, comme le montre les Figures 6a-6b. Les deux bobines 30, 31 sont couplées.

Plus précisément, une première borne 60.1 du premier condensateur 60 de la première cellule 50 est reliée à la masse 113, une deuxième borne 60.2 du premier condensateur 60 de la première cellule 50 est reliée à une première borne 30.1 de la bobine 30 de la première cellule 50, une deuxième borne 30.2 de la bobine 30 de la première cellule 50 est reliée à une première borne 62.2 du deuxième condensateur 62 de la première cellule 50 et une deuxième borne 62.1 du condensateur 62 de la première cellule 50 est reliée à la masse 113. De même, une première borne 61.2 du premier condensateur 61 de la deuxième cellule 51 est reliée à la masse 113, une deuxième borne 61.1 du premier condensateur 61 de la deuxième cellule 51 est reliée à une première borne 31.1 de la bobine 31 de la deuxième cellule 51, une deuxième borne 31.2 de la bobine 31 de la deuxième cellule 51 est reliée à une première borne 63.1 du deuxième condensateur 63 de la deuxième cellule 51 et une deuxième borne 63.2 du condensateur 63 de la deuxième cellule 51 est reliée à la masse 113.

Selon un mode de réalisation, l'inductance créée par le dispositif 1 de filtrage est de quelques micro Henry.

En variante, comme le montre la Figure 5, la structure 10 en matériau magnétique ne comporte pas de bras 14 mais deux bras 14.1, 14.2 de diamètre D2 positionnés à l'intérieur de l'ouverture 27. La partie de l'ouverture 27 positionnée entre les deux bras 14.1, 14.2 est appelée entrefer 16. Cet entrefer 16 permet d'éviter la saturation du noyau 10 en matériau magnétique et de conserver une inductance de valeur suffisante pour assurer le filtrage. L'épaisseur de l'entrefer 16 est comprise entre cent micromètres et un millimètre.

La position des bobinages 35, 36, 37, 38 par rapport aux plans 70, 71 de masse permet de réduire les couplages capacitif des bobines 30, 31 de sorte que le dispositif 1 de filtrage soit performant sur la gamme de fréquence la plus élevée du spectre des émissions conduites et rayonnées.

Les bobinages 35, 36, 37, 38 sont réalisés dans les sens qui permettent d'obtenir deux bobines 30, 31 couplées de mode commun ou de mode différentiel. Si les bobinages 35, 36 de la bobine 30 et les bobinages 37, 38 de la bobine 31 sont enroulés selon le même sens, par exemple dans le sens des aiguilles d'une montre, les deux bobines 30, 31 couplées sont de mode commun. Si les bobinages 35, 36 de la bobine 30 et les bobinages 37, 38 de la bobine 31 sont enroulés selon des sens contraires, par exemple les bobinages 35, 36 sont enroulés dans le sens des aiguilles d'une montre et les bobinages 37, 38 sont enroulés dans le sens contraire des aiguilles d'une montre, les deux bobines 30, 31 couplées sont de mode différentiel.

Lorsque les bobines 30, 31 couplées sont de mode commun, le dispositif 1 de filtrage filtre des parasites de mode commun. Lorsque les bobines 30, 31 couplées sont de mode différentiel, le dispositif 1 de filtrage filtre des parasites de mode différentiel.

La Figure 7 montre le dispositif 1 de filtrage vu de dessus, lorsque ce dispositif de filtrage est positionné entre un convertisseur de puissance, du côté de l'alimentation et un RSIL (« *Réseau de Stabilisation d'Impédances de Lignes* ») ou un réseau de distribution électrique. Les perturbations présentes dans le convertisseur de puissance sont filtrées, afin d'être inférieures au seuil défini par les normes, par le dispositif 1 de filtrage et ne pénètrent ainsi pas dans le RSIL.

Les plans 80, 81 sont respectivement les plans positifs et négatifs étant reliés du côté de l'alimentation, et les plans 82, 83 sont respectivement les plans positifs et négatifs étant reliés au RSIL ou au réseau de distribution électrique. Les plans 80-83 sont positionnés à l'extérieur de la zone délimitée par le noyau 10.

Le positionnement des plans 80-83 par rapport aux plans 70-71 de masse permettent de créer une capacité plus importante que la capacité créée par le positionnement des bobinages 35-38 par rapport aux plans 70, 71 de masse.

Le circuit 5 imprimé du dispositif 1 de filtrage n'intègre pas de matériau magnétique, ce qui facilite la fabrication du circuit 5 imprimé, réduit les coûts, et assure une fiabilité conforme aux exigences industrielles.

En variante, le nombre de couches de matériau isolant et de matériau à forte permittivité est plus grand. La symétrie du circuit 5 imprimé et l'alternance entre une couche de matériau à forte permittivité et une couche de matériau isolant sont respectées.

En variante, on intercale une couche supplémentaire de matériau isolant entre les couches 20, 25 et entre les couches 26, 22 Les bobinages 35, 37 sont alors positionnés entre la première couche supplémentaire de matériau isolant et la couche 20 et les bobinages 36, 38 sont alors positionnés entre la deuxième couche supplémentaire de matériau isolant et la couche 22.

Dans un exemple, les couches 20- 22 sont réalisées FR4, les couches 25, 26 sont réalisées en C-ply et le noyau 10 est réalisé en ferrite. La permittivité relative *εᵣ* du C-ply est de huit ou seize.

## Revendications

1. Dispositif (1) de filtrage CEM comportant :
- un circuit (5) imprimé comportant au moins deux couches (25, 26) parallèles de matériau à forte permittivité et au moins trois couches (20, 21, 22) de matériau isolant
- la première couche (25) de matériau à forte permittivité étant positionnée entre une première couche (20) de matériau isolant et une deuxième couche (21) de matériau isolant, ladite première couche (25) de matériau à forte permittivité comportant sur une face étant en contact avec la première couche (20) de matériau isolant un plan (80) négatif et un plan (81) positif, ces deux plans (80, 81) étant reliés du côté d'une alimentation et comportant sur une face étant en contact avec la deuxième couche (21) de matériau isolant un plan (70) de masse,
- la deuxième couche (26) de matériau à forte permittivité étant positionnée entre la deuxième couche (21) de matériau isolant et la troisième couche (22) de matériau isolant, ladite deuxième couche (26) de matériau à forte permittivité comportant sur une face étant en contact avec la deuxième couche (21) de matériau isolant un plan (82) positif et un plan (83) négatif, ces deux plans (82, 83) étant reliés à un Réseau de Stabilisation d'Impédances de Lignes ou à un réseau de distribution électrique et comportant sur une face étant en contact avec la deuxième couche (21) de matériau isolant un plan (71) de masse,
les deux couches (25, 26) de matériau à forte permittivité étant parallèles entre elles et aux couches (20, 21, 22) de matériau isolant,
- un noyau (10) en matériau magnétique comportant trois bras (13, 14, 15) cylindriques traversant perpendiculairement les couches (20-22, 25, 26), les couches (20-22, 25, 26) comportant chacune trois ouvertures circulaires, de sorte que lorsque les couches (20-22, 25, 26) sont empilées, les ouvertures circulaires forment trois ouvertures (26-28) cylindriques dans lesquelles sont positionnées les trois bras (13, 14, 15) du noyau (10),
- au moins deux bobinages (35, 36) s'enroulant autour du premier bras (13) du noyau (10) en matériau magnétique, ces bobinages (35, 36) et le premier bras (13) formant une première bobine (30),
- au moins deux bobinages (37, 38) s'enroulant autour du deuxième bras (15) du noyau (10) en matériau magnétique, ces bobinages (37, 38) et le deuxième bras (15) formant une deuxième bobine (31), les deux bobines (30, 31) étant des bobines couplées,
**caractérisé en ce que** le noyau (10) en matériau magnétique comporte un entrefer (16) séparant le bras (14) positionné entre le premier et le deuxième bras, en deux bras (14.1, 14.2) et deux plaques parallèles aux couches du circuit imprimé, (11, 12), chacune positionnée à une extrémité des trois bras (13, 14, 15).

2. Dispositif de filtrage selon la revendication 1, **caractérisé en ce que** :
- le premier bobinage (35, 37) de chaque bobine (30, 31) est positionné sur la face supérieure de la première couche (25) de matériau à forte permittivité étant en contact avec la première couche (20) de matériau isolant,
- le deuxième bobinage (36, 38) de chaque bobine (30, 31) est positionné sur la face inférieure de la deuxième couche (26) de matériau à forte permittivité étant en contact avec la deuxième couche (22) de matériau isolant.

3. Dispositif de filtrage selon l'une au moins des revendications 1 à 2, **caractérisé en ce que** les bobinages (35-38) des deux bobines (30, 31) sont plans.

4. Dispositif de filtrage selon l'une au moins des revendications 1 à 3, **caractérisé en ce que** les bobinages (35-38) des deux bobines (30, 31) sont enroulés dans le même sens, permettant de créer des bobines (30, 31) couplées de mode commun.

5. Dispositif de filtrage selon l'une au moins des revendications 1 à 4, **caractérisé en ce que** les bobinages (35, 36) de la première bobine (30) sont enroulés dans le sens contraire de l'enroulement des bobinages (37, 38) de la deuxième bobine (31), permettant de créer des bobines (30, 31) couplées de mode différentiel.

6. Dispositif de filtrage selon l'une au moins des revendications 1 à 5, **caractérisé en ce que** les couches (25, 26) de matériau à forte permittivité sont en matériau de type C-ply.

7. Dispositif de filtrage selon l'une au moins des revendications 1 à 6, **caractérisé en ce que** le noyau (10) en matériau magnétique est en ferrite.

8. Dispositif de filtrage selon l'une au moins des revendications 1 à 7, **caractérisé en ce que** les couches (20-22) de matériau diélectrique sont en matériau de type FR4.

9. Dispositif de filtrage selon l'une au moins des revendications 1 à 8, **caractérisé en ce que** le circuit (5) imprimé et les bras (13-15) du noyau (10) sont de hauteur (H1) comprise entre un millimètre et trois millimètres.

## Patentansprüche

1. EMV-Filtervorrichtung (1), die aufweist:
- eine Leiterplatte (5), die mindestens zwei parallele Schichten (25, 26) aus Material starker Permittivität und mindestens drei Schichten (20, 21, 22) aus Isoliermaterial aufweist,
- wobei die erste Schicht (25) aus Material starker Permittivität zwischen einer ersten Schicht (20) aus Isoliermaterial und einer zweiten Schicht (21) aus Isoliermaterial positioniert ist, wobei die erste Schicht (25) aus Material starker Permittivität auf einer Seite, die mit der ersten Schicht (20) aus Isoliermaterial in Kontakt ist, eine negative Ebene (80) und eine positive Ebene (81) aufweist, wobei diese zwei Ebenen (80, 81) auf der Seite einer Versorgung verbunden sind, und auf einer Seite, die mit der zweiten Schicht (21) aus Isoliermaterial in Kontakt ist, eine Masseebene (70) aufweist,
- wobei die zweite Schicht (26) aus Material starker Permittivität zwischen der zweiten Schicht (21) aus Isoliermaterial und der dritten Schicht (22) aus Isoliermaterial positioniert ist, wobei die zweite Schicht (26) aus Material starker Permittivität auf einer Seite, die mit der zweiten Schicht (21) aus Isoliermaterial in Kontakt ist, eine positive Ebene (82) und eine negative Ebene (83) aufweist, wobei diese zwei Ebenen (82, 83) mit einem Netzimpedanz-Stabilisierungsnetzwerk oder mit einem Stromverteilungsnetz verbunden sind, und auf einer Seite, die mit der zweiten Schicht (21) aus Isoliermaterial in Kontakt ist, eine Masseebene (71) aufweist,
wobei die zwei Schichten (25, 26) aus Material starker Permittivität zueinander und zu den Schichten (20, 21, 22) aus Isoliermaterial parallel sind,
- einen Kern (10) aus magnetischem Material, der drei zylindrische Arme (13, 14, 15) aufweist, die die Schichten (20-22, 25, 26) lotrecht durchqueren, wobei die Schichten (20-22, 25, 26) je drei kreisförmige Öffnungen aufweisen, so dass, wenn die Schichten (20-22, 25, 26) gestapelt sind, die kreisförmigen Öffnungen drei zylindrische Öffnungen (26-28) bilden, in denen die drei Arme (13, 14, 15) des Kerns (10) positioniert sind,
- mindestens zwei Wicklungen (35, 36), die sich um den ersten Arm (13) des Kerns (10) aus magnetischem Material wickeln, wobei diese Wicklungen (35, 36) und der erste Arm (13) eine erste Spule (30) bilden,
- mindestens zwei Wicklungen (37, 38), die sich um den zweiten Arm (15) des Kerns (10) aus magnetischem Material wickeln, wobei diese Wicklungen (37, 38) und der zweite Arm (15) eine zweite Spule (31) bilden,
wobei die zwei Spulen (30, 31) gekoppelte Spulen sind,
**dadurch gekennzeichnet, dass** der Kern (10) aus magnetischem Material einen Luftspalt (16), der den zwischen dem ersten und dem zweiten Arm positionierten Arm (14) in zwei Arme (14.1, 14.2) trennt, und zwei Platten (11, 12) parallel zu den Schichten der Leiterplatte aufweist, die je an einem Ende der drei Arme (13, 14, 15) positioniert sind.

2. Filtervorrichtung nach Anspruch 1, **dadurch gekennzeichnet, dass**:
- die erste Wicklung (35, 37) jeder Spule (30, 31) auf der Oberseite der ersten Schicht (25) aus Material starker Permittivität positioniert ist, die mit der ersten Schicht (20) aus Isoliermaterial in Kontakt ist,
- die zweite Wicklung (36, 38) jeder Spule (30, 31) auf der Unterseite der zweiten Schicht (26) aus Material starker Permittivität positioniert ist, die mit der zweiten Schicht (22) aus Isoliermaterial in Kontakt ist.

3. Filtervorrichtung nach mindestens einem der Ansprüche 1 bis 2, **dadurch gekennzeichnet, dass** die Wicklungen (35-38) der zwei Spulen (30, 31) eben sind.

4. Filtervorrichtung nach mindestens einem der Ansprüche 1 bis 3, **dadurch gekennzeichnet, dass** die Wicklungen (35-38) der zwei Spulen (30, 31) in gleicher Richtung gewickelt sind, was es ermöglicht, gekoppelte Spulen (30, 31) im Gleichtakt zu erzeugen.

5. Filtervorrichtung nach mindestens einem der Ansprüche 1 bis 4, **dadurch gekennzeichnet, dass** die Wicklungen (35, 36) der ersten Spule (30) in Gegenrichtung zur Wickelrichtung der Wicklungen (37, 38) der zweiten Spule (31) gewickelt sind, was es ermöglicht, gekoppelt Spulen (30, 31) im Gegentaktbetrieb zu erzeugen.

6. Filtervorrichtung nach mindestens einem der Ansprüche 1 bis 5, **dadurch gekennzeichnet, dass** die Schichten (25, 26) aus Material starker Permittivität aus Material der Art C-ply sind.

7. Filtervorrichtung nach mindestens einem der Ansprüche 1 bis 6, **dadurch gekennzeichnet, dass** der Kern (10) aus magnetischem Material aus Ferrit ist.

8. Filtervorrichtung nach mindestens einem der Ansprüche 1 bis 7, **dadurch gekennzeichnet, dass** die Schichten (20-22) aus dielektrischem Material aus Material der Art FR4 sind.

9. Filtervorrichtung nach mindestens einem der Ansprüche 1 bis 8, **dadurch gekennzeichnet, dass** die Leiterplatte (5) und die Arme (13-15) des Kerns (10) eine Höhe (H1) zwischen 1 Millimeter und 3 Millimeter haben.

## Claims

1. EMC filtering device (1) comprising:
- a printed circuit (5) comprising at least two parallel layers (25, 26) of high permittivity material and at least three layers (20, 21, 22) of insulating material
- the first layer (25) of high permittivity material being positioned between a first layer (20) of insulating material and a second layer (21) of insulating material, the said first layer (25) of high permittivity material comprising on one face in contact with the first layer (20) of insulating material a negative plane (80) and a positive plane (81), these two planes (80, 81) being connected on the side of a power supply and comprising on a face in contact with the second layer (21) of insulating material an earthing plane (70),
- the second layer (26) of high permittivity material being positioned between the second layer (21) of insulating material and the third layer (22) of insulating material, the said second layer (26) of high permittivity material comprising on a face in contact with the second layer (21) of insulating material a positive plane (82) and a negative plane (83), these two planes (82, 83) being connected to a line impedance stabilization network or to an electrical distribution network and comprising on a face in contact with the second layer (21) of insulating material an earthing plane (71),
the two layers (25, 26) of high permittivity material being parallel to one another and to the layers (20, 21, 22) of insulating material,
- a magnetic core (10) comprising three cylindrical arms (13, 14, 15) passing at right angles through the layers (20-22, 25, 26), the layers (20-22, 25, 26) each comprising three circular openings so that when the layers (20-22, 25, 26) are stacked, the circular openings form three cylindrical openings (26-28) in which the three arms (13, 14, 15) of the core (10) are positioned,
- at least two windings (35, 36) wound around the first arm (13) of the magnetic core (10), these windings (35, 36) and the first arm (13) forming a first coil (30),
- at least two windings (37, 38) wound around the second arm (15) of the magnetic core (10), these windings (37, 38) and the second arm (15) forming a second coil (31),
the two coils (30, 31) being coupled coils,
**characterized in that** the magnetic core (10) comprises a gap (16) dividing the arm (14) that is positioned between the first and second arms into two arms (14.1, 14.2) and two plates parallel to the layers of the printed circuit (11, 12), each plate being positioned at one end of the three arms (13, 14, 15).

2. Filtering device according to Claim 1, **characterized in that**:
- the first winding (35, 37) of each coil (30, 31) is positioned on the upper face of the first layer (25) of high permittivity material in contact with the first layer (20) of insulating material,
- the second winding (36, 38) of each coil (30, 31) is positioned on the lower face of the second layer (26) of high permittivity material in contact with the second layer (22) of insulating material.

3. Filtering device according to at least one of Claims 1 and 2, **characterized in that** the windings (35-38) of the two coils (30, 31) are flat.

4. Filtering device according to at least one of Claims 1 to 3, **characterized in that** the windings (35-38) of the two coils (30, 31) are wound in the same direction, making it possible to create common mode coupled coils (30, 31).

5. Filtering device according to at least one of Claims 1 to 4, **characterized in that** the windings (35, 36) of the first coil (30) are wound in the opposite direction to the winding of the windings (37, 38) of the second coil (31), making it possible to create differential mode coupled coils (30, 31).

6. Filtering device according to at least one of Claims 1 to 5, **characterized in that** the layers (25, 26) of high permittivity material are made of a material of C-ply type.

7. Filtering device according to at least one of Claims 1 to 6, **characterized in that** the magnetic core (10) is made of ferrite.

8. Filtering device according to at least one of Claims 1 to 7, **characterized in that** the layers (20-22) of dielectric material are made of a material of FR4 type.

9. Filtering device according to at least one of Claims 1 to 8, **characterized in that** the printed circuit (5) and the arms (13-15) of the core (10) have a height (H1) comprised between one millimetre and three millimetres.
